Europäisches Patentamt

(19) European Patent Office

Office européen des brevets

(11) EP 0 858 579 B1

(12) **EUROPEAN PATENT SPECIFICATION**

(45) Date of publication and mention
of the grant of the patent:
**09.04.2003 Bulletin 2003/15**

(51) Int Cl.[7]: **F28F 19/06**, B01J 19/00,
C23C 14/22, C23C 14/48

(21) Application number: **96935150.1**

(22) Date of filing: **04.11.1996**

(86) International application number:
**PCT/GB96/02681**

(87) International publication number:
**WO 97/016692 (09.05.1997 Gazette 1997/20)**

(54) **MODIFICATION OF METAL SURFACES**

VERÄNDERUNG VON METALLOBERFLÄCHEN

MODIFICATION DE SURFACES METALLIQUES

(84) Designated Contracting States:
**AT DE DK ES FR IT NL PT SE**

(30) Priority: **02.11.1995 GB 9522458**

(43) Date of publication of application:
**19.08.1998 Bulletin 1998/34**

(73) Proprietor: **UNIVERSITY OF SURREY**
**Guildford, Surrey GU2 5XH (GB)**

(72) Inventors:
• **ZHAO, Qi**
**Guildford, Surrey GU1 4DG (GB)**
• **MÜLLER-STEINHAGEN, Hans**
**Guildford, Surrey GU2 5XH (GB)**

(74) Representative: **Knott, Stephen Gilbert et al**
**MATHISEN, MACARA & CO.**
**The Coach House**
**6-8 Swakeleys Road**
**Ickenham Uxbridge UB10 8BZ (GB)**

(56) References cited:
EP-A- 0 540 084          WO-A-94/01029
GB-A- 2 066 696

• DATABASE WPI Section Ch, Week 8509 Derwent
Publications Ltd., London, GB; Class A32, AN
85-052299 XP002025043 & JP 60 008 057 A
(NIPPON OIL SEAL IND) , 16 January 1985
• INTERNATIONAL JOURNAL OF HEAT AND
MASS TRANSFER, NOV. 1991, UK, vol. 34, no.
11, ISSN 0017-9310, pages 2833-2835,
XP000617105 QI ZHAO ET AL: "Surface
materials with dropwise condensation made by
ion implantation technology"
• PATENT ABSTRACTS OF JAPAN vol. 014, no.
388 (M-1014), 22 August 1990 & JP 02 146430 A
(MATSUSHITA ELECTRIC IND CO LTD), 5 June
1990,
• 7TH INTERNATIONAL CONFERENCE ON ION
IMPLANTATION TECHNOLOGY, KYOTO,
JAPAN, 7-10 JUNE 1988, vol. B37-38, ISSN
0168-583X, NUCLEAR INSTRUMENTS &
METHODS IN PHYSICS RESEARCH, SECTION B
(BEAM INTERACTIONS WITH MATERIALS AND
ATOMS), FEB. 1989, NETHERLANDS, pages
661-666, XP000111377 IWAKI M: "Formation of
metal surface layers with high performance by
ion implantation"

## Description

The invention relates generally to the modification of metal surfaces and in particular, to the modification of such surfaces to reduce the formation of deposits from fluids in which the surfaces operate.

One such surface is a metal heat transfer surface. The formation of deposits on heat transfer surfaces is a major problem, costing UK industry an estimated £1000 million per year. Investigation of methods of reducing the formation of these deposits has received much attention in the past but it is still an unsolved problem.

One form of heat transfer surface is a heat exchanger surface. Many industries suffer from heat exchanger fouling problems which, due to the increased thermal resistance of the deposits formed on the heat exchangers, must typically be over designed by 10-200%. In addition, these deposits cause loss of production whilst additional maintenance is carried out on the plant to remove the deposits.

Another form of heat transfer surface is a heating element surface. There are significant costs to private households which arise from the deposition of hardness salts, such as $CaCO_3$ and $CaSO_4$, on the heating elements of appliances such as washing machines, dishwashers and kettles.

A wide range of chemical additives can be used to reduce the formation of deposits on heat transfer surfaces. Phosphates and silicates are usually added to counter the activity of calcium and magnesium ions. However, these chemicals generate additional production and operation costs and are generally harmful to the environment.

Examples of other surfaces of this kind are pump-impeller surfaces, oil well surfaces, pipeline surfaces, separator surfaces.

The International Journal of Heat and Mass Transfer, vol.34 No.11, 1991 pages 2833 to 2835 discloses the modification of metal surfaces by ion implantation to reduce dropwise condensation. WO 94/01029 discloses a non-stick coating of PTFE on a metal surface. JP-A-60 008057 discloses a metal body coated by sputtering with a film of a fluorine resin to reduce surface tension when the body is used in a condenser.

According to the invention, there is provided a method of inhibiting the deposition of substance on to a metal heat transfer surface for operation in a fluid containing at least one said substance comprising reducing the interaction energy between said surface and said substance by modifying a layer of the metal heat transfer surface by implantation with ions or deposition with ions or plasma such that the deposition of said substance is inhibited for a period in excess of 200 hours.

Some embodiments of the invention will now be described by way of example only, with reference to the accompanying diagrammatic drawings in which:

Figure 1 is a schematic representation of a nucleate pool boiling rig;

Figure 2 is a cross-sectional view on II-II of the heater rod in Figure 1;

Figure 3 is a graph of $\alpha$ vs time for stainless steel heater rods, both modified and untreated;

Figure 4 is a photograph of a treated heater rod after use;

Figure 5 is a schematic representation of one form of dynamic mixing ion implantation equipment; and

Figure 6 is a schematic representation of a second form of dynamic mixing ion implantation equipment.

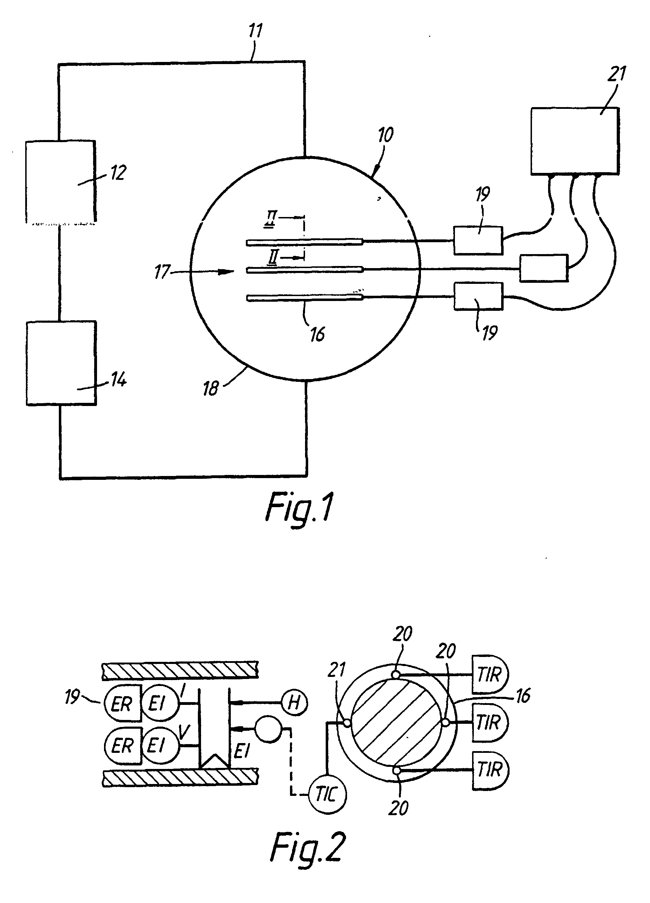

A first embodiment of the invention will now be described in relation to stainless steel heater rods for use in the nucleate pool boiling rig of Figures 1 and 2.

As shown in Figures 1 and 2, the pool boiling rig 1 consists of a boiling section 10, a flow loop 11 containing condensing 12 and preheating 14 sections, heater rods 16 with power control units 19, and instrumentation 21 to provide monitoring indication and data acquisition inputs.

The boiling section is a 300mm diameter cylindrical stainless steel vessel 18 with a 30 litre capacity with glass view ports at each end. The vessel has three ports in its curved outer surface and each port receives a respective precision electric resistance stainless steel heater rod 16. The middle heater rod 16 intersects the centre line of the cylindrical vessel 18.

The heater rods 16 are 400mm in length with a 10mm diameter.

Only a central 100mm section of each rod is heated in the test. Each heater rod 16 has four chromel-constantan (NiCr-CuNi) thermocouples 20 (E-Type) embedded in it (see Figure 2). Three of the thermocouples 20 are used to monitor the temperature of the heater rod 16. One of the thermocouples 20 is used as a trip input for a power supply 21 for the heater rods 16. Should the internal temperature of the heater rod exceed a defined limit, the power supply 21 will be cut off.

The thermocouples 20 are calibrated in accordance with standard procedures.

Prior to installation in the pool boiling rig 1, the surface layer of each of the heater rods 16 is treated using an ion implantation technique.

Ion implantation is a method of modifying the surface of a metal by implanting ions of various species. Implantation of the ions in a surface layer produces different alloys in the first 1-3 $\mu$m of the metal. This reduces the surface energy of the metal because the bonding energy and the concentration of free electrons at the metal surface are reduced and the entropy of the metal surface is increased. Surface energy, $E_b$ can be expressed as a function of surface internal energy, $U_b$, temperature, T, and surface entropy, $S_b$:

$$E_b = U_b - TS_b.$$

A major component of $S_b$ is the contribution due to disorder in the surface, which increases when foreign elements are implanted.

In a first embodiment of the invention, silicon fluoride ions ($SiF_3^+$) are implanted in the surface layer of a stainless steel heater rod 16 using a dose of $1 \times 10^{17}$ ions/cm$^2$ at an energy of 1.9 MeV.

In use, stainless steel heating rods 16 so implanted are fitted in the boiling vessel and the boiling vessel 18 is filled with water containing $CaSO_4$ at a concentration of 1.2 g/l. The temperature of the central sections of the heater rods 16 are raised to a temperature above 100°C by operation of the power supply 21. The pressure in the rig is maintained at a constant level of between 1.0 and 1.1 bar, which corresponds to a bulk temperature of 100-103°C. Then, unimplanted heating rods are also mounted in the boiling vessel 18 and similarly heated.

The heat transfer coefficient for nucleate pool boiling of each heater rod 16 (implanted and unimplanted), $\alpha$, is measured during the test by the following method:

$$\alpha = \frac{q}{\Delta T} \qquad [1]$$

$$q = \frac{V \cdot I}{A} \qquad [2]$$

q is the heat flux, which is calculated by measuring the voltage drop V across the heater 16 and the current I through the heater. A is the heated surface area in square metres. $\Delta T$ is the temperature difference between the surface of the heater rod 16, $T_S$ and the bulk solution $T_B$:

$$\Delta T = T_S - T_B \qquad [3]$$

$$T_S = \frac{1}{3} \sum_{j=1}^{3} \left( T_{w,j} - \frac{q}{(\lambda_w / S_j)} \right) \quad \ldots\ldots [4]$$

$T_B$ and $T_{wj}$ are measured by thermocouples. $S_j$ is the distance of the heater thermocouples from the surface of the heater rod and $\lambda_w$ is the thermal conductivity of the heater rod material. ($\lambda_w/S_j$) values are obtained by calibration.

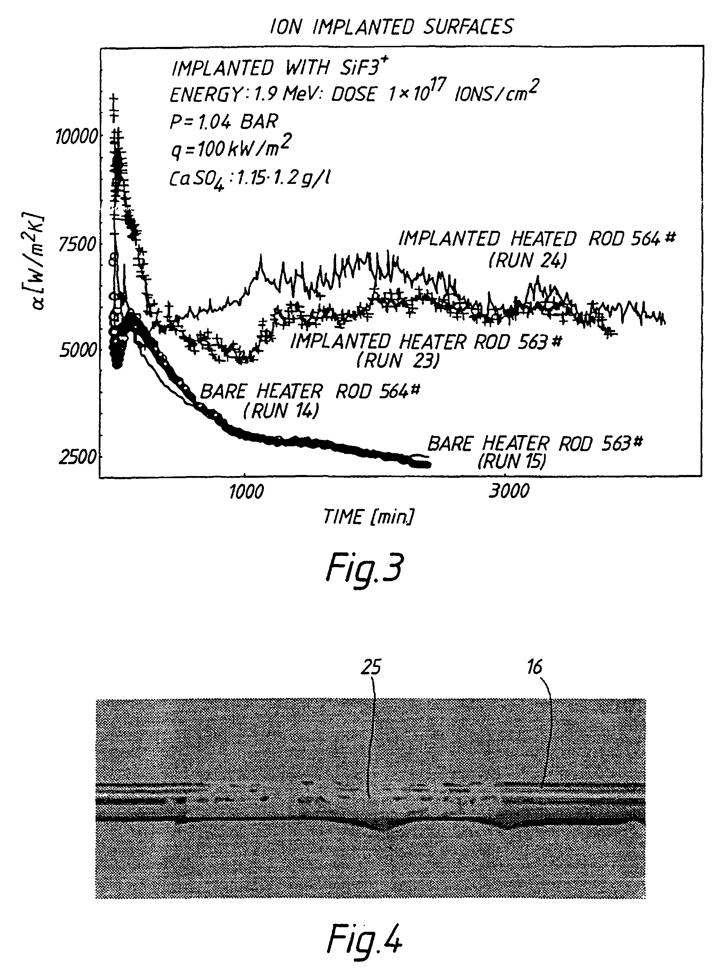

Referring to Figure 3, there is plotted the variation in heat transfer coefficient ($\alpha$) against time for a surface modified stainless steel heater rod 16 implanted with $SiF_3^+$ ions, and for an unmodified stainless steel heater rod 16 for comparison purposes.

Initially, $\alpha$ for both the surface modified and the unmodified heater rod fell. Subsequently, $\alpha$ remained approximately constant for the surface treated heater rod, whereas for the untreated rod, $\alpha$ fell at an almost constant rate. On conclusion of the test, the $\alpha$ value of the treated rod 16 was 100% higher than that of the untreated rod 16.

During the test, different behaviour for the bare and treated heater rods was observed: For example, at a heat flux of 100 kW/m$^2$, the surface temperature of the implanted heater rod 16 increased to about 120°C, while the surface temperature of the unimplanted heater rod increased above 130°C.

On examination, the implanted heater rod 16 had a thin, incomplete layer of deposit 25 on its surface. (See Figure 4).

Further tests carried out using stainless steel heater rods 16 with $SiF_3^+$ implanted in the surface layer yielded similar results. Heat flux, $CaSO_4$ concentration and implantation energy and implantation dose were varied and found to affect the deposition behaviour.

It will be appreciated that other ions could be implanted in the surface layer of the stainless steel rod. For example, Chromium (Cr), Fluorine (F), Carbon (C), Hydrogen (H) and Nitrogen (N) ions or different combinations of these ions could be used instead of $SiF_3^+$ ions.

In addition, the heater rods 16 need not be stainless steel, but could be any other suitable metal, such as titanium, copper or copper alloys such as brass.

In a second embodiment of the invention, a different surface modification technique is used.

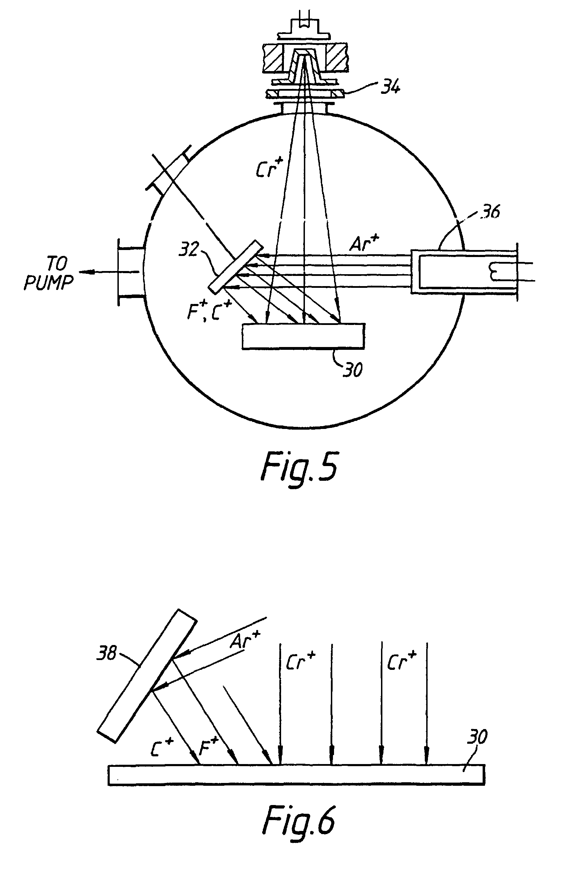

In this case, dynamic mixing ion implantation is used. Dynamic mixing ion implantation implants simultaneously two or more species of ion in the surface layer of a metal article. For example, (See Figure 5), a metal surface 30 can be bombarded with $Cr^+$ ions and $F^+$ ions. This is achieved by using a sputter target 32 and two types of ion sources - a higher energy ion source 34 and a lower energy source 36. The lower energy ion source 36 is used to bombard the sputter target 32, which will then emit ions. The ions, together with the ions from a higher energy ion source 34 will be implanted simultaneously into the metal surface 30.

If a Teflon™ target 38 is used $Cr^+$ and $F^+$ ions can be implanted at the same time as $Cr^+$ ions are implanted from a chromium target as shown in Figure 6.

In a third embodiment of the invention, the surface energy of the metal is reduced by modifying the surface layer using a Magnetron Sputtering Ion Plating technique.

Magnetron sputtering ion plating is a combination of magnetron sputtering and ion plating. It takes a magnetron sputtering target as evaporation source, and hence does not need a resistance or electron beam to evaporate the materials to be plated. Magnetron sputtering targets may be of cylindrical shape or rectangular shape and there is almost no size limit. Therefore, magnetron sputtering ion plating can be used to treat industrially-sized surfaces. Two conditions must be met for the technique: (1) the magnetic field must be normal to the electric field; (2) the direction of magnetic flux lines must be parallel to the negative pole magnetron sputtering target.

In this technique, ions of Cr, F, C, H or N⁻ or different combinations of these ions can be implanted in the metal surface layer of a heater rod 16. The alloy surface layer is >1 μm. thick to reduce the long range forces between the alloy and the metal to a minimum.

A further embodiment of the invention uses Plasma Enhanced Chemical Vapour Deposition (PECVD) to deposit silicon compounds onto the metal article.

PECVD can be used to produce a thin film on the surface of a heater rod 16. Two commercially available reactors are a parallel plate reactor and a hot-wall reactor. In the parallel plate reactor, the heater rod 16 is positioned on a grounded electrode which can be heated, and unreacted gases are introduced at the centre of bottom electrodes. In hot-wall systems, electrodes are alternately connected to RF power and to ground. An advantage of this latter system is the large load as compared to the parallel plate reactors. Recently, a new type of reactor has been developed, which differs from the usual parallel-plate chambers by the strong asymmetry of the electrode arrangement, and has many advantages: it can increase the degree of crosslinkage of the thin film and thus, the density of the thin film by its special highly energetic ion bombardment and it allows the outside coating of three-dimensional substrates such as heater rods 16.

PECVD can be used to deposit silicon compounds such as amorphous $Si_3N_4$, amorphous Si and SiC. In addition, thin films of hexamethyldisalazane, tetraethylothosilicate and trimethylvinysilane can be generated.

It will be appreciated that in all of the above embodiments, there are many other materials that can be implanted or deposited on the required surface.

In addition, it is possible to use a combination of the above techniques. For example, PECVD and ion implantation can be used together to first deposit a layer onto the metal article and then implant that layer with ions of the required species.

While the above embodiments have been described with reference to heater rods 16, it will be appreciated that they can be applied to any heat transfer surface including heat exchanger surfaces.

The above described techniques act to reduce the formation of a deposit on a metal heat transfer surface by reducing the surface energy of the metal.

The formation of a deposit on a metal heat transfer surface may be considered as an interaction between the deposit and the surface layer of the metal. If the interaction energy between the deposit and the surface layer is reduced, adhesion between them becomes much weaker and the formation of the deposit may be inhibited.

As metals possess a high surface energy, the formation of a layer of lower surface energy deposit on the metal surface will reduce the free energy of the system. It is this reduction in free energy which is the driving force required for the deposition to occur.

If the surface energy of the metal article is reduced by a surface layer modification technique, the driving force for the deposition to occur is removed and as a result, deposits will not form or there will be insufficient force to allow significant build-up of deposits. The surface will, therefore, possess an intrinsic resistance to the formation of deposits.

For a given heat transfer surface, the amount of heat transferred is directly proportional to the heat transfer coefficient $\alpha$. Similarly for a required heat output, the required heat transfer surface area is directly proportional to the heat transfer coefficient $\alpha$. This means that if the heat transfer coefficient can be maintained at a constant high value, a smaller heat transfer surface can be used whilst maintaining high heat output.

Generally, the heat transfer coefficient has its highest value for a clean heat transfer surface and decreases with increasing deposit thickness. It is, therefore, desirable to keep the heat transfer surface clean or the deposit layer thin.

The surface modification as described above has been shown to lengthen the time before a scale deposit starts to form. Additionally, the heat transfer coefficient remains approximately constant after the build-up of a thin deposit layer. This means that the heat exchanger does not require frequent cleaning or expensive and environmentally harmful chemical additive treatment.

The ability of the surface treated, as described in the above-mentioned processes, to maintain a high heat transfer coefficient is due to the reduced stickability of the deposit on the treated heat transfer surface. The deposit formed does not firmly adhere to the heat transfer surface due to the lower surface energy of the surface and the action of the fluid in the heat exchange leads to regular spalling of the deposit due to fluid shear stresses, bubble growth and departure mechanisms.

The surface treatments described above delay the formation of an initial layer of scale and so the heat transfer coefficient $\alpha$ is maintained at its highest value. Further, once an initial deposit layer starts to form, the treated surface has an intrinsic resistance to the formation of deposits so that there is no significant build-up of deposits and thus no substantial lowering of the value of $\alpha$ in the long term.

## Claims

1.  A method of inhibiting the deposition of a substance on to a metal heat transfer surface (16,30) for operation in a fluid containing at least one said substance comprising reducing the interaction energy between said surface (16,30) and said substance by modifying a layer of the metal heat transfer surface (16,30) by implantation with ions or deposition with ions or plasma such that the deposition of said substance is inhibited for a period in excess of 200 hours.

2.  A method according to claim 1, in which said ions are implanted by dynamic mixing ion implantation.

3.  A method according to claim 1, in which the deposition of said substance is inhibited by sputtering said surface (16,30) with ions by magnetron sputtering ion plating.

4.  A method according to claim 1, in which the deposition of said substance is inhibited by coating said surface (16,30) by plasma enhanced chemical vapour deposition.

5.  A method according to claim 1, in which the deposition of said substance is inhibited by coating said surface (16,30) with the ions/plasma by a combination of plasma enhanced chemical vapour deposition and ion implantation.

6.  A method according to claim 1, in which the deposition of said substance is inhibited by coating said surface (16,30) with the ions/plasma by a combination of plasma enhanced chemical vapour deposition and magnetron sputtering ion plating.

7.  A method according to any one of claims 1 to 6, in which the ions or plasma are of Cr or F or C or H or N or are from PTFE.

8.  A method according to claim 4, in which the ions or plasma are from Si or SiC.

9.  A method according to claim 4, in which the ions or plasma are from the monomer of hexamethyldisalazane (HMDS-N) or tetraethylothosilicate (TEOS) or trimethylvinylsilane.

10. A method according to any preceding claim, in which the heat transfer surface is copper or a copper alloy or stainless steel or titanium.

11. A method according to any one of claims 1 to 11 comprising incorporating the metal heat transfer surface (16,30) in a heat exchange system including an inlet and an outlet and then flowing said fluid between said inlet and outlet and over said metal heat transfer surface.

## Patentansprüche

1.  Verfahren zum Hemmen der Abscheidung einer Substanz auf einer metallischen Wärmeübertragungs-Oberfläche (16, 30), die In einer wenigstens die vorgenannte Substanz enthaltenden Flüssigkeit eingesetzt wird. wobei die Wechselwirkungsenergie zwischen der Oberfläche (16, 30) und der Substanz verringert wird, indem eine Schicht der metallischen Wärmeübertragungs-Oberfläche (16, 30) durch Implantation mit Ionen oder durch Abscheidung von Ionen oder Plasma derart modifiziert wird, dass die Abscheidung der Substanz während einer Dauer von mehr als 200 Stunden gehemmt wird.

2.  Vetfahren nach Anspruch 1, wobei die Ionen durch dynamische Mischungsionenimplantation implantiert werden.

3.  Verfahren nach Anspruch 1, wobei die Abscheidung der Substanz durch Besputtem der Oberfläche (16, 30) mit Ionen mittels Magnetronzerstäubungs-Ionenplattierung gehemmt wird.

4.  Verfahren nach Anspruch 1, wobei die Abscheidung der Substanz durch Beschichten der Oberfläche (16, 30) mittels plasmaverstärkter chemischer Dampfabscheidung gehemmt wird.

5.  Verfahren nach Anspruch 1, wobei die Abscheidung der Substanz durch Beschichten der Oberfläche (16, 30) mit Ionen/Plasma mittels einer Kombination aus plasmaverstärkter chemischer Dampfabscheidung und Ionenimplantation gehemmt wird.

6.  Verfahren nach Anspruch 1, wobei die Abscheidung der Substanz durch Beschichten der Oberfläche (16, 30) mit Ionen/Plasma durch eine Kombination aus plasmaverstärkter chemischer Dampfabscheidung und Magnetronzerstäubungslonenplattierung gehemmt wird.

7.  Verfahren nach wenigstens einem der Ansprüche 1 bis 6, wobei die Ionen oder das Plasma aus Cr oder F oder C oder H oder N oder aus PTFE erzeugt sind.

8.  Verfahren nach Anspruch 4, wobei die Ionen oder das Plasma aus Si oder SiC erzeugt sind.

9.  Verfahren nach Anspruch 4, wobei die Ionen oder das Plasma aus dem Monomer des Hexamethyldisalazan (HMDS-N) oder Tetraethylothosilicat (TEOS) oder Trimethylvinylsilan erzeugt sind.

**10.** Verfahren nach wenigstens einem der vorstehenden Ansprüche, wobei die Wärmeübertragungs-Oberfläche (16, 30) Kupfer oder eine Kupferlegierung oder korrosionsbeständigen Stahl oder Titan umfasst.

**11.** Verfahren nach wenigstens einem der Ansprüche 1 bis 11, wobei die metallische Wärmeübertragungs-Oberfläche (16, 30) in einem Wärmetauschersystem vorgesehen ist, das einen Einlass und einen Auslass umfasst, wobei die Flüssigkeit zwischen dem Einlass und dem Auslass über die metallische Wärmeübertragungs-Oberfläche (16, 30) strömt

## Revendications

**1.** Procédé d'inhibition du dépôt d'une substance sur une surface métallique (16, 30) de transfert de chaleur destiné à travailler dans un fluide contenant au moins une dite substance, comprenant la réduction de l'énergie d'inter-action entre ladite surface (16, 30) et ladite substance par modification d'une couche de la surface métallique (16, 30) de transfert de chaleur par implantation d'ions ou par dépôt d'ions ou d'un plasma tel que le dépôt de la substance est inhibé pendant une période qui dépasse 200 h.

**2.** Procédé selon la revendication 1, dans lequel lesdits ions sont implantés par implantation ionique par mélange dynamique.

**3.** Procédé selon la revendication 1, dans lequel le dépôt de ladite substance est inhibé par pulvérisation de la surface (16, 30) par des ions formée par dépôt ionique par pulvérisation dans un magnétron.

**4.** Procédé selon la revendication 1, dans lequel le dépôt de ladite substance est inhibé par revêtement de la surface (16, 30) par dépôt chimique en phase vapeur renforcé par un plasma.

**5.** Procédé selon la revendication 1, dans lequel le dépôt de ladite substance est inhibé par revêtement de ladite surface (16, 30) par des ions et un plasma, par combinaison d'un dépôt chimique en phase vapeur renforcé par un plasma et d'une implantation ionique.

**6.** Procédé selon la revendication 1, dans lequel le dépôt de ladite substance est inhibé par revêtement de la surface (16, 30) par les ions ou un plasma par une combinaison d'un dépôt chimique en phase vapeur renforcé par un plasma et d'un dépôt ionique par pulvérisation dans un magnétron.

**7.** Procédé selon l'une quelconque des revendications 1 à 6, dans lequel les ions ou le plasma sont formés par Cr ou F ou C ou H ou N ou sont tirés de PTFE.

**8.** Procédé selon la revendication 4, dans lequel les ions ou le plasma sont formés à partir de Si ou SiC.

**9.** Procédé selon la revendication 1, dans lequel les ions ou le plasma sont tirés du monomère d'hexaméthyldisalazane (HMDS-M) ou de tétraéthylorthosilicate (TEOS) ou de triméthylvinylsilane.

**10.** Procédé selon l'une quelconque des revendications précédentes, dans lequel la surface de transfert de chaleur est formée de cuivre ou d'alliage de cuivre ou d'acier inoxydable ou de titane.

**11.** Procédé selon l'une quelconque des revendications 1 à 11, comprenant l'incorporation de la surface métallique (16, 30) de transfert de chaleur à un système d'échange de chaleur qui comporte une entrée et une sortie, puis la circulation du fluide entre l'entrée et la sortie et sur la surface métallique de transfert de chaleur.

**Fig.1**

**Fig.2**

ION IMPLANTED SURFACES

Fig.3

Fig.4

8

Fig.5

Fig.6